**Europäisches Patentamt**

**European Patent Office**

**Office européen des brevets**

(19)

(11) Veröffentlichungsnummer: **0 010 307**
**B1**

(12) # EUROPÄISCHE PATENTSCHRIFT

(45) Veröffentlichungstag der Patentschrift:
**12.05.82**

(51) Int. Cl.³: **C 04 B 35/52**, C 04 B 41/06,
C 01 B 33/02

(21) Anmeldenummer: **79104048.8**

(22) Anmeldetag: **19.10.79**

(54) Verfahren zum Schutz von Kohlenstoffkörpern.

(30) Priorität: **19.10.78 DE 2845459**

(43) Veröffentlichungstag der Anmeldung:
**30.04.80 Patentblatt 80/9**

(45) Bekanntmachung des Hinweises auf die Patenterteilung:
**12.05.82 Patentblatt 82/19**

(84) Benannte Vertragsstaaten:
**BE DE FR GB IT NL**

(56) Entgegenhaltungen:
**keine**

(73) Patentinhaber: **Consortium für elektrochemische Industrie GmbH, Zielstattstrasse 20, D-8000 München 70 (DE)**

(72) Erfinder: **Dietl, Josef, Dr. Dipl.-Phys., Albanistrasse 11, D-8000 München 90 (DE)**
Erfinder: **Wohlschläger, Michael, Friedlandstrasse 13, D-8034 Unterpfaffenhofen (DE)**

EP 0 010 307 B1

BUNDESDRUCKEREI BERLIN

## Verfahren zum Schutz von Kohlenstoffkörpern

Gegenstand der Erfindung ist ein Verfahren zum Schutz von Kohlenstoffkörpern gegen den Angriff von schmelzflüssigem Silicium durch Aufbringen einer trennenden Schutzschicht.

Kohlenstofformkörper und hierbei insbesondere Graphitformkörper werden in der Technik aufgrund ihrer ausgezeichneten Wärmestandzeiten weit verbreitet für Hochtemperaturprozesse eingesetzt. Während aber Graphittiegel beispielsweise für das Tiegelziehen von Germanium nach dem Czochralski-Verfahren verwendet werden können, ist dies beim Tiegelziehen von Silicium nicht möglich, da bei den dabei auftretenden hohen Temperaturen die Siliciumschmelze den Graphittiegel unter Bildung von Siliciumcarbid angreift. Überhaupt ist bei der Herstellung von hochreinem Silicum für Bauelemente der direkte Kontakt von Silicium mit Kohlenstoff zu vermeiden, da sich dieser im Silicium anreichert und zu Leckströmen in aus derartigem Material gefertigten Bauelementen führen würde. Aus diesen Gründen werden beim Tiegelziehen von Silicium Tiegel aus wesentlich teuerem Quarz oder Quarzglas eingesetzt, die zwar in der Regel ebenfalls nur einmal verwendbar sind, aber erst beim Erstarren des im Tiegel verbleibenden Restsiliciums zu Bruch gehen und nicht schon, wie im Falle der Verwendung von Kohlenstoff- oder Graphittiegeln, bereits während eines solchen Ziehprozesses. Aus der DE-A 20 09 459 ist ein Verfahren zur Herstellung von Siliciumformkörpern bekannt, bei welchem Silicium in einem Kohlenstoffkörper aufgeschmolzen wird. Hierbei muß die Hohlform aus Kohlenstoff gekühlt, außerdem die mit Silicium in Berührung kommende Oberfläche mit einem Formkörper aus gesinterter Quarzwolle und/oder gesintertem Quarzsand abgedeckt werden. Das Silicium selbst wird in der Form mittels induktiver Beheizung geschmolzen und anschließend durch Absenken aus der induktiv beheizten Zone abgekühlt. Aber auch hier treten bei größeren Siliciumformkörpern Schwierigkeiten auf, weil durch die lange Verweilzeit des geschmolzenen Siliciums in der präparierten Schmelzform bis zum völligen Aufschmelzen des gesamten Siliciums die Schutzschicht aus gesinterter Quarzwolle und/oder Quarzsand zerstört wird. Außerdem ist die Herstellung einer flüssigkeitsgekühlten Form ziemlich aufwendig. Ein Schutz derartiger Hohlformen aus Graphit, deren Oberfläche mit gesinterter Quarzwolle oder gesintertem Quarzsand bzw. gesintertem Siliciumnitrid beschichtet ist, ist höchstens dann ausreichend, wenn flüssiges Silicium in dieser Form nicht aufgeschmolzen, sondern lediglich eingegossen wird und durch entsprechende Kühlung der Form sofort zum Erstarren gebracht wird (vgl. hierzu beispielsweise DE-C 2 244 211).

Aus der US-A 2 992 127 schließlich ist es bekannt, Graphittiegel gegenüber Oxidationsprozessen und insbesondere gegenüber dem Angriff von schmelzflüssigem Silicium dadurch resistent zu machen, daß die Oberfläche des Graphitkörpers mit pulvrigem Silicium abgedeckt wird, welches beim Erhitzen des Graphitkörpers auf über 1360° C in einer Inertgasatmosphäre oberflächlich zu einer zusammenhängenden Schicht aus Siliciumcarbid abreagiert. Gemäß diesem Verfahren kann in einem zweiten Schritt zusätzlich noch Siliciumnitrid in pulvriger Form aufgetragen und bei erhöhter Temperatur mit dem Formkörper zusammengesintert werden. Der Nachteil dieses Verfahrens liegt aber darin, daß gekrümmte Kohlenstofformkörper nicht mit einer gleichmäßig dicken Schicht von Siliciumcarbid bzw. Siliciumnitrid überzogen werden können. Zum anderen resultiert bei diesen Sinterprozessen lediglich eine Oberflächenschicht mit sehr schlechter Porendichtigkeit. Schmelzflüssiges Silicium dringt mit der Zeit in diese Poren ein und greift den unterliegenden Graphitkörper zersetzend an. Außerdem kann umgekehrt Kohlenstoff aus dem Graphitkörper über entsprechende Poren in der Überzugsschicht als störender Fremdstoff in die Siliciumschmelze und somit zum Teil auch in den aus dieser Schmelze gezogenen Siliciumstab eindringen.

Aus der US-A 3 871 872 ist es schließlich bekannt, in flüssige Metallbäder eintauchende Graphitrührer durch eine Schicht aus Erdalkalialumosilikaten zu schützen. Würde man aber beispielsweise Formkörper aus Kohlenstoff — die in der zitierten amerikanischen Patentanmeldung allerdings nicht angesprochen werden — mit einer derartigen Schicht aus Erdalkalialumosilikat abdecken, so könnte der durch Eingießen erhaltene Siliciumformkörper nach dem Erstarren unter seinen Schmelzpunkt nicht ohne weiteres aus dem Formkörper gelöst werden, da die in der amerikanischen Patentschrift genannten Erdalkalialumosilikate einen Schmelzpunkt aufweisen, der oberhalb dem des Siliciums liegt. In diesem Falle könnte zwar der Kontakt zwischen schmelzflüssigem Silicium und dem Kohlenstoff des Tiegels unterbunden werden, nicht aber die beim Abkühlen und Trennen von Form und Formkörper eintretende Zerstörung des Tiegels.

Aus den US-Patentschriften 3 225 399 und 3 993 474 ist es bekannt, beim Vergießen von Metallen in oder durch Kohlenstofformkörper Gießpulver zuzusetzen, deren Schmelzpunkt unter dem der zu vergießenden Metalle liegt. Die dort genannten Gießpulver lassen sich aber allein schon wegen ihres niedrigen Schmelzpunktes bei der Verarbeitung von schmelzflüssigem Silicium nicht einsetzen.

Aus der DE-A 2 706 175 ist es schließlich bekannt, Siliciumstäube durch Zuschlag einer Silikatschlacke mit Gehalt an Kupfer wieder einzuschmelzen, ein derartiges Schlackensystem würde aber zur Vergiftung von Silicium für die Halbleiterindustrie führen.

Der Erfindung lag daher die Aufgabe zugrunde, eine Schutzschicht für Kohlenstoffkörper zu finden, die die Oberfläche vor dem Angriff schmelzflüssigen Siliciums schützt und es erlaubt, erstarrtes Silicium aus derartig beschichteten Kohlenstofformkörpern zu entnehmen, ohne daß die Form dabei zerstört wird und diese somit mehrfach verwendet werden kann.

Gelöst wird diese Aufgabe dadurch, daß auf die zu schützende Oberfläche des Kohlenstoffkörpers eine Trennschicht aus Erdalkalifluoriden im Gemisch mit 0 bis 70 Mol-% Erdalkalisilikaten, ggf. mit gegenüber der reinen Stöchiometrie MO SiO$_2$, wobei M für Erdalkalimetall steht, erhöhtem SiO$_2$-Anteil von etwa 10% oder mehr, benetzend aufgebracht wird. Gemäß der Erfindung werden dabei die Fluoride und ggf. Silikate der Erdalkalielemente Magnesium, Kalzium, Strontium und Barium eingesetzt, wobei allein schon wegen der geringeren Kosten Kalzium- und Magnesiumverbindungen bevorzugt werden. Die Erdalkalifluoride können dabei allein, im Gemisch mit weiteren Erdalkalifluoriden oder im Gemisch mit Erdalkalisilikaten in der oben angegebenen Menge eingesetzt werden. Geeignet sind beispielsweise Gemische aus Kalziumfluorid und Magnesiumfluorid, wobei durch Veränderung des Mischungsverhältnisses der Schmelzpunkt bis auf 950°C (bei 45 Mol-% Magnesiumfluorid im Gemisch) abgesenkt werden kann. Geeignet sind außerdem Mischungen aus Magnesiumfluorid mit Kalziumsilikat oder Magnesiumfluorid mit Magnesiumsilikat, Mischungen aus Kalziumfluorid mit Magnesiumsilikat sowie vorzugsweise Mischungen aus Kalziumfluorid und Kalziumsilikat, dies insbesondere aufgrund des gegenüber Magnesiumfluorid erheblich niedrigeren Dampfdruckes des Kalziumfluorids.

Auf die zu schützenden Kohlenstoffkörper wird zweckmäßig eine etwa 0,01 bis 2 mm, vorzugsweise 0,1 bis 0,5 mm dicke Trennschicht der genannten Schmelzen aufgebracht. Um eine Schicht dieser Dicke aufbringen zu können, müssen die Kohlenstoffteile von der Schutzschmelze benetzt werden. Diese Benetzung läßt sich im Falle der Fluorid-Silikat-Mischschmelzen beispielsweise durch einen Überschuß an Kieselsäure (SiO$_2$) von etwa 10% oder mehr, bezogen auf die stöchiometrische Zusammensetzung des Erdalkalisilikates (MO · SiO$_2$, M = Erdalkaliatom) erreichen, wodurch die Obergrenze dadurch gegeben ist, daß der Kieselsäurezusatz zu einer höherschmelzenden Schicht führt, die Trennschicht andererseits aber definitionsgemäß am Schmelzpunkt von Silicium noch flüssig sein soll. Eine weitere Möglichkeit, eine Benetzung von Trennschicht und Kohlenstoffkörper zu erreichen, liegt. darin, die für die Trennschicht bereitgestellte Mischung aus Erdalkalifluoriden und Erdalkalisilikaten beim Aufbringen auf den Kohlenstoffkörper auf eine Temperatur über 1600°C zu erhitzen.

Die dritte und bevorzugt angewandte Methode besteht darin, der Schutzschmelze elementares Silicium in Mengen über 2 Gew.-%, vorzugsweise etwa 2 bis 5 Gew.-%, zuzusetzen. Diese Methode ist sowohl bei reinen Fluoridschmelzen wie auch bei Fluorid-Silikat-Mischschmelzen anwendbar.

Die Beschichtung der Kohlenstoffkörper läßt sich dabei auf verschiedene Art und Weise erreichen, beispielsweise durch Aufbringen und Schmelzen von Pulverschichten, wobei die Einzelkomponenten der für die Trennschicht einzusetzenden Mischung in fester pulvriger Form miteinander vermischt und möglichst gleichmäßig auf die Oberfläche des zu schützenden Kohlenstofformkörpers aufgestreut werden. Eine weitere Möglichkeit besteht darin, die für die Schutzschicht vorgesehene Mischung aufzuschmelzen und auf die zu schützenden Teile des Kohlenstoffkörpers aufzusprühen. Eine weitere und bevorzugt angewandte Technik besteht schließlich darin, die zu schützenden Kohlenstoffkörper in die für die Trennschicht vorgesehene Schutzschmelze einzutauchen bzw. von innen zu schützende Kohlenstofformkörper mit Schutzschmelze zu füllen und diese anschließend auszugießen. Die zu schützenden Kohlenstofformkörper werden dabei zweckmäßig einige Minuten, ausreichend meist etwa 5 bis 15 Minuten, in der Schmelze belassen, bevor sie aus der Schmelze gezogen oder die Schmelze aus gekrümmten, innen zu schützenden Kohlenstoffkörpern ausgegossen wird. Maßgeblich ist hierbei auch, ob die Kohlenstoffkörper in kaltem oder heißem Zustand in die Schmelze eingetaucht bzw. mit Schutzschmelze gefüllt werden. Die Zeit ist erforderlich, um ein Aufziehen der Schutzschmelze auf der Oberfläche der zu schützenden Kohlenstoffkörper zu ermöglichen, wobei wiederum eine gleichmäßige Benetzung von Schutzschicht und Kohlenstoff zwingend erforderlich ist.

Nach dem Abfließen der überschüssigen Schutzschmelze bleibt eine dünne Schicht an den Kohlenstoffteilen haften. Die Dicke der Schicht wird durch die Viskosität der Schutzschmelze bestimmt, die wiederum durch Zusammensetzung und Temperatur eingestellt werden kann. Beispielsweise läßt sich die Viskosität der Mischschmelze Kalziumfluorid-Kalziumsilikat durch Erhöhen des Kalziumfluoridanteils um ein Mehrfaches vermindern. Ideal geeignet sind dabei beispielsweise Mischungen aus Kalziumfluorid mit Kalziumsilikat mit einem Anteil von 40 bis 70 Mol-% Kalziumsilikat.

Kohlenstoffkörper, die auf diese Art und Weise geschützt werden können, sind beispielsweise Schmelztiegel, Kokillen, Verdränger, Rohre, Überlaufrinnen, Gasfrischlanzen, Rühr- und Schöpfwerkzeuge, Widerstandsheizer sowie Schlitzdüsen beim Bänderziehen.

Wählt man eine Zusammensetzung der Schutzschicht mit sehr niedrigem Schmelzpunkt, also beispielsweise reine Fluoridschmelzen oder fluoridreiche Silikatschmelzen, so bleibt diese Schicht während des Abkühlvorgangs noch längere Zeit nach dem Erstarren des Siliciums als flüssige Trennschicht zwischen Siliciumkristall und Kohlenstoffkörper bestehen. Die Korrelation von Schmelzpunkt und Anteil der Mischungspartner läßt sich dabei aus den Phasendiagrammen entnehmen (vgl. beispielsweise J. Mukerji »Phase Equilibrium Diagramm«, J. of Am. Ceramic Soc. 48, 210 (1965)). Schutzschichten mit niedrigem Schmelzpunkt sind demnach beispielsweise Mischungen aus Kalziumsilikat mit etwa 40 Mol-% Kalziumfluorid, deren Schmelzpunkt etwa 300° unter dem des Siliciums liegt. Noch tiefer liegt der Schmelzpunkt beispielsweise von einer Mischung aus Kalziumfluorid mit 45 Mol-% Magnesiumfluorid (950°C).

Die flüssige Schutzschicht verhindert das Festhaften des erstarrenden Siliciums an den Kohlenstoffkörpern und läßt damit Verschiebungen zu, die zu einem Abbau mechanischer Spannungen führen. Drüber hinaus wird ein problemloses Trennen des erstarrten Siliciums von den Kohlenstofformteilen ermöglicht. Als Anwendungsbeispiele für derartig niedrigschmelzende flüssige Trennschichten bietet sich beispielsweise die Kristallisation von Silicium in konisch geformten Kohlenstofftiegeln an, da hierbei der Tiegel durch die Ausdehnung des Siliciums beim Erstarren nicht mehr gesprengt wird. Auch die grobkörnige Kristallisation des Siliciums läßt sich hierdurch erzielen, da die Flüssigtrennschicht die erzwungene Keimbildung an der festen Kohlenstoffwand verhindert und die Kristallisation ohne Gefahr der Reaktion des Siliciums mit dem Tiegel beliebig langsam eingeleitet werden kann. Auch Graphitkokillen, wie sie zur Herstellung von polykristallinem Solarzellengrundmaterial eingesetzt werden, lassen sich vorteilhaft mit einer derartigen flüssigen Trennschicht einsetzen, da die darin vergossenen Siliciumplatten eine für den Wirkungsgrad der späteren Solarzelle günstig gröbere Kristallstruktur aufweisen und sich nach dem Erstarren, während die Trennschicht noch flüssig ist, aus der Kokille entfernen lassen, so daß diese unzerstört für einen zweiten Gießprozeß bereitgestellt werden kann. Für die Herstellung komplizierterer Siliciumformkörper lassen sich mehrteilige Graphitformen mit erfindungsgemäßer Flüssigtrennschicht einsetzen, welche nach dem Erstarren des Siliciums, aber vor dem Erstarren der Flüssigtrennschicht unzerstört von dem Siliciumformkörper abgezogen werden können.

Die Erfindung erlaubt den wiederholten Einsatz derartig geschützter Kohlenstoffkörper, wobei zweckmäßig die schützende Trennschicht von Zeit zu Zeit erneuert wird.

### Beispiel 1

Ein Graphittiegel in der äußeren Form eines Zylinders mit einem Durchmesser von 90 mm und einer Höhe von 90 mm, der innen so aufgebohrt ist, daß er einen halbkugelförmigen Boden mit einem Durchmesser von 70 mm aufweist, welcher sich nach oben leicht konisch unter einem Winkel von ca. 3° öffnet, bei einer Gesamttiefe von 75 mm wurde mit einer erfindungsgemäßen Trennschicht versehen. Zu diesem Zweck wurde er mit einer Schutzschmelze, bestehend aus 30 Gew.-% Kalziumfluorid und ca. 70 Gew.-% Magnesiumsilikat (30 Gew.-% $CaF_2$ + 35 Gew.-% MgO + 35 Gew.-% $SiO_2$) und 3 Gew.-% Siliciumpulver, bezogen auf den fluoridischen und silikatischen Anteil der Schutzschmelze, aufgefüllt und 10 Minuten bei einer Temperatur von ca. 1400°C belassen. Nach dem anschließenden Ausgießen der Schutzschmelze verblieb eine ca. 0,1 mm dicke Trennschicht an der zu schützenden Oberfläche.

Nachfolgend wurden 400 g Silicium in dem solcherart beschichteten Tiegel durch Hochfrequenzheizung aufgeschmolzen und durch Absenken des Tiegels aus der Hochfrequenzspule eine von unten nach oben gerichtete Kristallisation in dem erstarrenden Silicium hervorgerufen. Durch einfaches Umkippen wurde der gerichtet erstarrte Siliciumkristall dem Tiegel bei einer Temperatur von ca. 1250°C entnommen. Die Trennschicht war bei dieser Temperatur noch flüssig und der Graphittiegel verblieb unversehrt und konnte ohne Nachbehandlung für einen neuerlichen Aufschmelzprozeß von Silicium mit nachfolgender Erstarrung eingesetzt werden.

### Beispiel 2

Eine würfelförmige zweigeteilte Gießform aus Graphit mit den Abmessungen 100 × 100 × 100 mm und einer Wandstärke von 40 mm, welche in der Mitte geteilt war und in einer Würfelfläche eine Öffnung zum Eingießen aufwies, wurde in ein Schmelzbad, bestehend aus 40 Gew.-% Kalziumfluorid und ca. 60 Gew.-% Kalziumsilikat (40 Gew.-% $CaF_2$ + 30 Gew.-% CaO + 30 Gew.-% $SiO_2$), dem zur Benetzung des Graphits wiederum 3 Gew.-% Silicumpulver, bezogen auf den fluoridischen und silikatischen Anteil der Schutzschmelze, zugesetzt war, 10 Minuten bei einer Temperatur von ca. 1400°C eingetaucht. Nach dem Herausziehen der Gießform aus dem Schmelzbad verblieb an der Oberfläche allseitig eine Trennschicht von etwa 0,1 mm. In einem Graphittiegel, welche durch Eintauchen in das nämliche Schmelzbad mit der selben Trennschicht geschützt war, wurden 1500 g Silicium aufgeschmolzen und in die beschichtete Gießform eingegossen. Durch einfaches Trennen der beiden Teile der Gießform wurde der erstarrte Siliciumgußblock bei einer Temperatur von ca. 1200°C entnommen.

Die allseitige Beschichtung, die durch das Eintauchen der Gießform und des Schmelztiegels in die Kalziumfluorid-Kalziumsilikat-Schmelze erreicht wurde, erlaubte das Arbeiten unter oxidierender Atmosphäre (Luft) ohne störenden Abbrand des Graphits.

## Beispiel 3

Es wurde genau wie in Beispiel 2 gearbeitet, lediglich wurde ein Schmelzbad, bestehend aus 55 Gew.-% Kalziumfluorid und 45 Gew.-% Magnesiumfluorid eingesetzt. Der erstarrte Siliciumgußblock wurde durch Trennen der beiden Teile der Gießform bei einer Temperatur von ca. 1050°C, also bei einer Temperatur, bei welcher die Trennschicht noch flüssig war, entnommen. Auch hier blieben Gießform und Schmelztiegel unversehrt und konnten ohne Nachbehandlung wieder verwendet werden.

## Patentansprüche

1. Verfahren zum Schutz von Kohlenstoffkörpern gegen den Angriff von schmelzflüssigem Silicium durch Aufbringen einer trennenden Schutzschicht mit einem Schmelzpunkt unterhalb dem des Siliciums, dadurch gekennzeichnet, daß auf die zu schützende Oberfläche des Kohlenstoffkörpers eine Trennschicht aus Erdalkalifluoriden im Gemisch mit 0 bis 70 Mol-% Erdalkalisilikaten, ggf. mit gegenüber der reinen Stöchiometrie MO SiO$_2$, wobei M für Erdalkalimetall steht, erhöhtem SiO$_2$-Anteil von etwa 10% oder mehr, benetzend aufgebracht wird.

2. Verfahren nach Anspruch 1, dadurch gekennzeichnet, daß als Trennschicht eine Mischung aus Kalziumfluorid und Kalziumsilikat aufgebracht wird.

3. Verfahren nach Anspruch 1, dadurch gekennzeichnet, daß als Trennschicht eine Mischung aus Kalziumfluorid mit 40 bis 70 Mol-% Kalziumsilikat aufgebracht wird.

4. Verfahren nach einem oder mehreren der Ansprüche 1 bis 3, dadurch gekennzeichnet, daß den als Trennschicht eingesetzten Mischungen zur besseren Benetzung 2 bis 5 Gew.-% Silicium zugesetzt werden.

5. Verfahren nach einem oder mehreren der Ansprüche 1 bis 4, dadurch gekennzeichnet, daß das Aufbringen der trennenden Schutzschicht durch kurzzeitiges Eintauchen des Kohlenstoffkörpers in die aufgeschmolzene Mischung aus Erdalkalifluoriden und ggfs. Erdalkalisilikaten erfolgt.

## Claims

1. Process for protecting carbon bodies against attack by molten silicon by applying a separating protective layer having a melting point lower than that of silicon, characterized in that a separating layer consisting of alkaline earth metal fluorides in admixture with 0 to 70 mole% of alkaline earth metal silicates is applied to the surface of the carbon body to be protected in such a manner as to wet is, said alkaline earth metal silicates optionally having an elevated SiO$_2$-proportion of approximately 10% or more as compared with the stoichiometric composition MO SiO$_2$, wherein M stands for alkaline earth metal.

2. Process according to claim 1, characterized in that a mixture of calcium fluoride and calcium silicate is applied as the separating layer.

3. Process according to claim 1, characterized in that a mixture of calcium fluoride with 40 to 70 mole% of calcium silicate is applied as the separating layer.

4. Process according to one or more of claims 1 to 3, characterized in that, in order to improve wetting, 2 to 5% by weight of silicon are added to the mixtures used as the separating layer.

5. Process according to one or more of claims 1 to 4, characterized in that the separating protective layer is applied by briefly immersing the carbon body in the molten mixture of alkaline earth metal fluorides and optionally alkaline earth metal silicates.

## Revendications

1. Procédé pour protéger des pièces en carbone contre l'attaque du silicium fondu, par application d'une couche protectrice de séparation dont le point de fusion est inférieur à celui du silicium, procédé caractérisé en ce qu'on applique avec mouillage sur la surface de la pièce en carbone à protéger une couche de séparation formée par des fluorures alcalino-terreux en mélange avec 0 à 70 moles% de silicates alcalino-terreux, et présentant éventuellement une proportion de SiO$_2$ supérieure d'environ 10% ou davantage par rapport à la stoéchiométrie pure MO SiO$_2$, où M représente un métal alcalino-terreux.

2. Procédé selon la revendication 1, caractérisé en ce qu'on applique comme couche de séparation un mélange de fluorure de calcium et de silicate de calcium.

3. Procédé selon la revendication 1, caractérisé en ce qu'on applique comme couche de séparation un mélange de fluorure de calcium avec 40 à 70 moles% de silicate de calcium.

4. Procédé selon une ou plusieurs des revendications 1 à 3, caractérisé en ce qu'on ajoute, pour améliorer le mouillage, 2 à 5% en poids de silicium aux mélanges utilisés comme couche de séparation.

5. Procédé selon une ou plusieurs des revendications 1 à 4, caractérisé en ce que l'application de la couche protectrice de séparation s'effectue par une courte immersion de la pièce en carbone dans le mélange fondu des fluorures alcalino-terreux et éventuellement des silicates alcalino-terreux.